# EUROPÄISCHE PATENTANMELDUNG

(11) **EP 1 301 064 A1**
(43) Veröffentlichungstag der Anmeldung: **09.04.2003**
(21) Anmeldenummer: 02020626.4
(22) Anmeldetag: 13.09.2002
(51) Int. Cl.: H05K 7/14, H05K 9/00

(54) **HF-geschirmter Baugruppenträger**

(30) Priorität: 08.10.2001 DE 10149445
(71) Anmelder: Schroff GmbH, D-75334 Straubenhardt (DE)
(72) Erfinder: Daub, Elmar, 76327 Pfinztal (DE); Fauth, Achim, 75334 Straubenhardt (DE)
(74) Vertreter: Durm, Frank, Dipl.-Ing.

(57) **Zusammenfassung**

Ein HF-geschirmter Baugruppenträger zur Aufnahme von elektronischen und/oder optischen Baugruppen umfasst zwei Seitenwände (1a, 1b), vordere und hintere Modulschienen (6a, 6b), die zwischen den Seitenwänden (1a, 1b) angeordnet sind und eine obere und eine untere Abdeckung (3, 4). Die Abdeckungen ( 3, 4)bestehen aus einem Wabenkamingitter (5) und einem umlaufenden Rahmen aus Metall, welcher mit dem Wabenkamingitter (5) elektrisch leitend verbunden ist. Die vorderen und hinteren Modulschienen (6a, 6b) bilden jeweils die vorderen bzw. hinteren Rahmenleisten des Rahmens. Die beiden seitlichen Rahmenleisten (7a, 7b) des Rahmens weisen Mittel zur Befestigung an den Seitenwänden (1a, 1b) auf.

## Beschreibung

Die Erfindung bezieht sich auf einen HF-geschirmten Baugruppenträger zur Aufnahme von elektronischen und/oder optischen Baugruppen, mit zwei Seitenwänden, vorderen und hinteren Modulschienen, die zwischen den Seitenwänden angeordnet sind, und einer oberen und einer unteren Abdeckung.

Die Erfindung findet Anwendung bei Baugruppenträgern, für die eine sehr hohe Schirmwirkung gegenüber äußeren elektromagnetischen Einflüssen gefordert wird oder in denen Baugruppen eingesetzt werden, die elektromagnetische Störungen erzeugen, die nicht in die Umgebung gelangen dürfen.

Hochfrequenzdichte Baugruppenträger und geeignete Mittel bzw. Maßnahmen zur Abschirmung sind bekannt. Die Schirmung eines aus einem Rahmengestell mit vier Modulschienen und zwei Seitenwänden zusammengesetzten Baugruppenträgers besteht üblicherweise aus den Seitenwänden selbst, einer Rückwand, einer Frontplatte sowie metallenen Abdeckungen oben und unten. Die Güte der Schirmwirkung eines solchen geschlossenen Gehäuses hängt zum einen von der Qualität des elektrischen Kontakts zwischen den umschließenden Bauteilen und zum anderen von der Größe und Anzahl der Öffnungen ab, die zum Zwecke der Belüftung in die Hülle des Baugruppenträgers eingebracht sind.

Eine gute elektrische Kontaktierung der einzelnen Bauteile wird durch Verwendung von dicht nebeneinander gesetzten Befestigungsschrauben oder mit Hilfe von elektrisch leitfähigen Dichtungen oder Federelementen erreicht. Besondere Schwierigkeiten bereiten jedoch die Fugen zwischen dem Gehäuse und den jeweiligen Abdeck- bzw. Abschirmelementen, die zum Zwecke der Wartung häufiger abgenommen werden müssen, wobei sich die Schirmwirkung auch nach mehrmaligem Abnehmen und Aufsetzen nicht verschlechtern darf.

Ein abgeschirmter Baugruppenträger der eingangs genannten Art ist aus der Patentschrift DE 42 23 322 C1 der Anmelderin bekannt. Das dort beschriebene Gehäuse stellt eine hochfrequenzdichte Kontaktierung zwischen einer lösbaren Abdeckung und den oberen Modulschienen eines Baugruppenträgers dadurch sicher, dass speziell ausgebildete Federelemente in Längsrinnen der oberen Modulschienen klemmend eingesetzt werden, in welche abgekantete schmale Randleisten der Abdeckung ebenfalls klemmend einsteckbar sind. Die HF-Abschirmung wird also relativ aufwendig durch zusätzliche Bauteile erzeugt.

Ein anderer Baugruppenträger, der aus einem Rahmengestell mit vier Querverbindungsschienen und zwei angeschraubten Seitenwänden besteht, ist aus der Druckschrift WO 00/21348 bekannt. Neben den beiden Seitenteilen wird der dort beschriebene Baugruppenträger von einer Vorderseite, einer Rückwand, einem Boden und einem oberen Abdeckteil umschlossen. Die einzelnen Bauteile sind mit den Querverbindungsschienen verschraubt, so dass ein elektrisch gut leitfähiger Kontakt besteht. Die Abschirmwirkung des Bauträgers wird dadurch verbessert, dass die Abdeckteile und die Querverbindungsschienen einstückig ausgeführt sind. Dadurch wird vermieden, dass zwischen dem Abdeckblech und den Verbindungsschienen Trennfugen entstehen, die nachträglich gegen Hochfrequenz abgedichtet werden müssen.

Den bekannten Baugruppenträgern ist gemeinsam, dass die zur Abdeckung verwendeten Bauteile als Bleche ausgeführt werden, welche von sich aus eine gute Schirmwirkung haben. Es entstehen damit vollständig oder weitgehend geschlossene Baugruppenträger, die entweder gar nicht oder nur unzureichend durchlüftet sind. Im Baugruppenträger erzeugte Wärme kann nur schlecht nach außen abgeführt werden.

Die vorranschreitende Technik führt zu immer höheren Packungsdichten der Baugruppen innerhalb der Baugruppenträger sowie zu immer höheren Taktraten, die vor allem bei Geräten im Computerbereich und im Mobilfunksektor, wie z.B. bei UMTS-Anwendungen, zu finden sind. Dadurch wird immer mehr Wärme innerhalb des Baugruppenträgers erzeugt. Auch eine Erhöhung der Leistungsaufnahme der einzelnen Bauelemente der Baugruppen hat eine steigende Wärmeabgabe zur Folge. Die Kühlung der eingebauten Elektronik läßt sich nur erreichen, wenn ausreichend Luft den Baugruppenträger durchströmen kann. Dazu müssen in die Bleche Löcher oder Öffnungen eingebracht werden, was jedoch grundsätzlich der HF-Schirmung entgegenwirkt.

Damit die Schirmwirkung auch für hohe Frequenzen nicht durch die Öffnungen verlorengeht, dürfen zur Perforation der Bleche nur kleine Löcher Verwendung finden. In der praktischen Anwendung ist der Durchmesser der Löcher auf maximal 4 mm begrenzt, damit auch hochfrequente elektromagnetische Störfelder im Gigahertz-Bereich noch hinreichend abgeschirmt werden. Die Löcher werden üblicherweise aus den geschlossenen Blechen im Nachhinein ausgestanzt. Dies läßt sich technisch nur realisieren, wenn zwischen benachbarten Löchern ausreichend breite Stege verbleiben. Dadurch ergibt sich aber ein ungünstiges Verhältnis zwischen der entstehenden Lochfläche und den verbleibenden Stegen. Der Perforationsgrad der Bleche, d.h. das Verhältnis von Gesamtöffnungsfläche aller Öffnungen zur Gesamtfläche des Bleches, ist verhältnismäßig klein. Der Luftstrom durch die Bleche und somit die Kühlung der im Baugruppenträger eingebauten Elektronik ist deshalb stark begrenzt. Eine Verbesserung der Lüftung könte nur durch die Verwendung größerer Löcher entstehen, was sich allerdings negativ auf die Schirmwirkung des Baugruppenträgers auswirken würde.

Der Erfindung liegt daher die Aufgabe zugrunde, einen HF-geschirmten Baugruppenträger der eingangs genannten Art zu schaffen, der bei hervorragender Schirmwirkung eine maximale Durchlüftung der internen Baugruppen ermöglicht.

Zur Lösung der Aufgabe wird von einem HF-geschirmten Baugruppenträger der im Oberbegriff des Patentanspruchs 1 definierten Art ausgegangen. Gelöst wird die Aufgabe erfindungsgemäß dadurch, dass die Abdeckungen aus einem Wabenkamingitter und einem umlaufenden Rahmen aus Metall bestehen, der Rahmen elektrisch leitend mit dem Wabenkamingitter verbunden ist, die vorderen und hinteren Modulschienen jeweils die vorderen und hinteren Rahmenleisten bilden und die seitlichen Rahmenleisten Mittel zur Befestigung an den Seitenwänden aufweisen.

Der Einsatz eines Wabenkamingitters als Abdeckung bietet eine maximale Durchströmung des Baugruppenträgers. Das Wabenkamingitter weist durch das günstige Verhältnis seiner Öffnungen zu den sehr schmalen Stegen zwischen den einzelnen Waben einen sehr hohen Perforationsgrad auf. Die Luft kann praktisch ungehindert von unten nach oben durch das Wabenkamingitter hindurch strömen. Trotz des geringen Strömungswiderstands verfügt das Wabenkamingitter aber über eine hervorragende Schirmwirkung, weil die einzelnen Waben kurze Hohlleiter darstellen, in denen hochfrequente elektromagnetische Wellen stark gedämpft werden.

Der das Wabenkamingitter umschließende Rahmen erhöht zum einen die Eigensteifigkeit und die Stabilität des Wabenkamingitters, so dass keine weiteren tragenden Elemente benötigt werden; die gesamte Fläche der Abdeckung kann somit als Wabenkamingitter ausgeführt werden. Zum anderen begradigt der Rahmen den Rand des Wabenkamingitters, der aufgrund der Geometrie seiner Wabenstruktur zackenförmig ausgebildet ist. Die Umrahmung ermöglicht es, das Wabenkamingitter problemlos in die rechtwinkligen Strukturen des Baugruppenträgers einzupassen.

Die vorderen und hinteren Modulschienen sind erfindungsgemäß Teil des Rahmens, wodurch die als Wabenkamingitter ausgebildete Fläche maximiert wird. Eine aufwendige HF-dichte Kontaktierung zwischen dem Rahmen und den Modulschienen entfällt. Auf den Einsatz herkömmlicher Schirmdichtungen oder Federelemente zur Überbrückung der Fugen zwischen dem Rahmen und der Modulschienen kann verzichtet werden. Zusätzlich wird das Wabenkamingitter durch die Integration der Modulschienen Teil der tragenden Struktur des Baugruppenträgers. Hierdurch wird die Stabilität erhöht.

Die an den seitlichen Rahmenleisten vorgesehenen Mittel zur Befestigung des Wabenkamingitters an den Seitenwänden ermöglichen es, die parallel zur Seitenwand entstehende Fuge zwischen der Seitenwand selbst und den Rahmenleisten zu minimieren. Durch den Einsatz mehrerer Befestigungsmittel wird die Fuge so stark verkürzt, dass sie auch für hohe Frequenzen eine dichte Verbindung darstellt.

In einer bevorzugten Ausführungsform sind die seitlichen Rahmenleisten mit den Seitenwänden verschraubt. Die Schrauben können mit optimalem Drehmoment angezogen werden, wodurch die Rahmenleiste ideal an der Seitenwand anliegt und die Schlitz- bzw. Fugenbreite minimiert wird. Weiterhin lassen sich die Schrauben auch wieder lösen, um die Abdeckung auszutauschen oder den Baugruppenträger zu demontieren. Zudem sind Schrauben generell ein kostengünstiges und einfach zu handhabendes Befestigungsmittel.

Vorteilhaft erweist sich eine Ausbildung mit nach innen weisender Längsnut in den Modulschienen, in die das Wabenkamingitter eingesetzt werden kann. Damit wird eine elektrisch leitfähige Verbindung zwischen den Modulschienen und dem Wabenkamingitter geschaffen, die auch für höchste Frequenzen einen geringen elektrischen Übergangswiderstand darstellt. Auf weitere kontaktierende Maßnahmen zwischen dem Wabenkamingitter und den Modulschienen kann durch diese Ausbildung verzichtet werden. Das in die Modulschienen eingesetzte Wabenkamingitter kann in die Längsnut eingepreßt oder mit leitfähigem Kleber verklebt sein.

Bevorzugt weisen die seitlichen Rahmenleisten ein nach innen offenes, U-förmiges Profil auf, das das Wabenkamingitter aufnimmt. Die U-förmige Profilleiste bildet einen geraden Abschluss des Wabenkamingitters und lässt sich einfach und kostengünstig herstellen. Das U-Profil hat die gleiche Funktion wie die Längsnut in den Modulschienen und gewährleistet eine gute elektrische Kontaktierung des Wabenkamingitters mit dem umlaufenden Rahmen. Durch einfaches Verpressen der U-Profile oder durch zusätzliches Verkleben mit leitfähigem Kleber kann das Wabenkamingitter mit den Modulschienen bzw. Rahmenleisten zuverlässig und dauerhaft verbunden werden.

Ein Ausführungsbeispiel der Erfindung wird nachstehend anhand der beigefügten Zeichnungen erläutert. Es zeigen:
- Figur 1: eine perspektivische Ansicht eines Baugruppenträgers;
- Figur 2: den Baugruppenträger aus Figur 1 mit abgehobener oberer Abdeckung; und
- Figur 2b: eine Detailzeichnung der vorderen Ecke der oberen Abdeckung im Querschnitt.

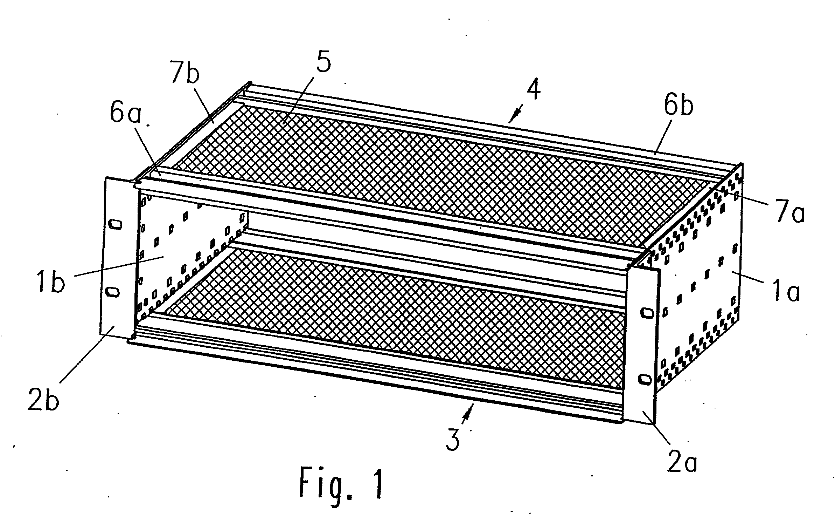

Gemäß Figur 1 hat der Baugruppenträger zwei parallele metallische Seitenwänden 1a, 1b, welche zur Befestigung an einem Rahmengestell jeweils einen Befestigungsflansch 2a, 2b tragen. Die beiden Seitenwände 1a, 1b sind an ihren vier Ecken mit einer unteren Abdeckung 3 und einer oberen Abdeckung 4 verschraubt.

Die Abdeckungen 3 und 4 bestehen aus jeweils einem Wabenkamingitter 5, das von einem umlaufenden Rahmen aus Metall eingefasst ist. Der Rahmen setzt sich aus einer vorderen und hinteren Modulschiene 6a, 6b und einer rechten und linken Rahmenleiste 7a, 7b zusammen.

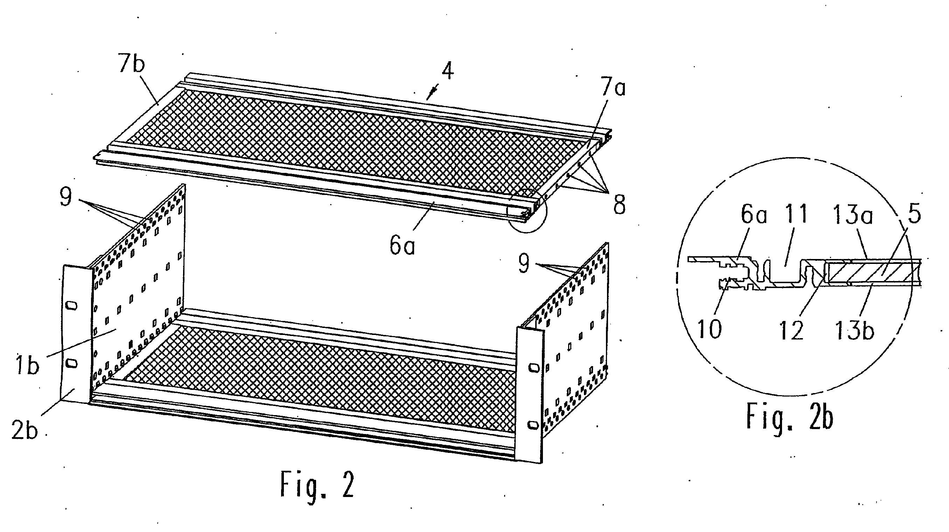

In Figur 2 wird die vom Baugruppenträger losgelöste obere Abdeckung 4 genauer dargestellt. Die Rahmenleisten 7a und 7b weisen äquidistant angeordnete Gewindebohrungen 8 auf. Die Seitenteile 1a, 1b weisen zu den Gewindebohrungen 8 in den Rahmenleisten 7a, 7b korrespondierende Bohrungen 9 auf, durch die (nicht dargestellte) Befestigungsschrauben hindurchragen können, um die Seitenteile 1a, 1b mit den Rahmenleisten 7a, 7b zu verschrauben.

Die vordere rechte Ecke der oberen Abdeckung 4 ist in Figur 2b im Schnitt detailliert dargestellt. Die Modulschiene 6a weist eine nach links geöffnete, typische Ausnehmung 10 auf, in die Teilfrontplatten von Baugruppen eingeschraubt werden können. In einer Längsrinne 11, die das Mittelteil der Modulschiene 6a bildet, können Federelemente und Blechabdeckungen befestigt werden, wie es bei herkömmlicher Verwendung der Modulschienen geschieht. In eine nach rechts geöffnete Längsnut 12 ist das Wabenkamingitter 5 eingesetzt. An die Modulschiene 6a stoßen rechts die beiden Schenkel 13a, 13b der U-förmigen rechten Rahmenleiste 7a an, welche das Wabenkamingitter 5 einfassen.

### Zusammenstellung der Bezugszeichen

- 1a, 1b: Seitenwände
- 2a, 2b: Befestigungsflansche
- 3: untere Abdeckung
- 4: obere Abdeckung
- 5: Wabenkamingitter
- 6a, 6b: Modulschiene
- 7a, 7b: Rahmenleiste
- 8: Gewindebohrungen
- 9: Bohrungen
- 10: Ausnehmung
- 11: Längsrinne
- 12: Längsnut
- 13a, 13b: Schenkel

## Patentansprüche

1. HF-geschirmter Baugruppenträger zur Aufnahme von elektronischen und/oder optischen Baugruppen mit
- zwei Seitenwänden,
- vorderen und hinteren Modulschienen, die zwischen den Seitenwänden angeordnet sind, und
- einer oberen und einer unteren Abdeckung,
**dadurch gekennzeichnet , dass**
- die Abdeckungen aus einem Wabenkamingitter (5) und einem umlaufenden Rahmen aus Metall bestehen, welcher mit dem Wabenkamingitter (5) elektrisch leitend verbunden ist,
- die vorderen und hinteren Modulschienen (6a, 6b) jeweils die vorderen bzw. hinteren Rahmenleisten des Rahmens bilden,
- die seitlichen Rahmenleisten (7a, 7b) des Rahmens Mittel zur Befestigung an den Seitenwänden (1a, 1b) aufweisen.

2. HF-geschirmter Baugruppenträger nach Anspruch 1, **dadurch gekennzeichnet, dass** die Seitenwände (1a, 1b) mit den seitlichen Rahmenleisten (7a, 7b) verschraubt sind.

3. HF-geschirmter Baugruppenträger nach Anspruch 1 oder 2, **dadurch gekennzeichnet, dass** die vorderen und hinteren Modulschienen (6a, 6b) jeweils eine nach innen weisende Längsnut (12) haben, in die das Wabenkamingitter (5) eingreift.

4. HF-geschirmter Baugruppenträger nach einem der Ansprüche 1 bis 3, **dadurch gekennzeichnet, dass** die seitlichen Rahmenleisten (7a, 7b) jeweils ein nach innen offenes, U-förmiges Profil haben und den Rand des Wabenkamingitters (5) umfassen.
